Europäisches Patentamt

(19) European Patent Office

Office européen des brevets

(11) Publication number: **0 014 395**
**B1**

## (12) EUROPEAN PATENT SPECIFICATION

(45) Date of publication of patent specification: **28.07.82**

(21) Application number: **80100391.4**

(22) Date of filing: **25.01.80**

(51) Int. Cl.³: **G 01 R 17/10, G 01 K 7/24, H 03 K 13/20**

(54) **Indicator circuit including a bridge circuit with means for error indication independent of voltage source variation.**

(30) Priority: **05.02.79 US 9329**

(43) Date of publication of application:
**20.08.80 Bulletin 80/17**

(45) Publication of the grant of the patent:
**28.07.82 Bulletin 82/30**

(84) Designated Contracting States:
**DE FR GB**

(56) References cited:
**US - A - 3 728 626**
**US - A - 3 978 471**

(73) Proprietor: **International Business Machines Corporation**
**Armonk, N.Y. 10504 (US)**

(72) Inventor: **Cunningham Jr., Joseph Edwin**
**4791 Dorchester Circle**
**Boulder, Colorado 80301 (US)**
Inventor: **Grombone, Anthony**
**9773 Phillips Road**
**Lafayette Colorado 80026 (US)**

(74) Representative: **Petersen, Richard Courtenay**
**IBM United Kingdom Patent Operations Hursley Park**
**Winchester Hants. SO21 2JN (GB)**

Courier Press, Leamington Spa, England.

Indicator circuit including a bridge circuit with means for error indication
independent of voltage source variation

This invention relates to indicator circuits having an output corresponding to the departure of a sensed condition from a particular condition. Such circuits have included a bridge circuit connected to a voltage source to produce a reference voltage, proportional to the voltage of the source, and an error voltage, the change in which from a "zero" point corresponding to the reference voltage is proportional to the departure of the condition sensed from the particular condition. That error voltage may then be converted into a digital quantity in order to take corrective action.

One of the significant problems relating to the use of bridge circuits is the output of the bridge circuit is not only affected by changes in the sensed condition, but may also be affected by variations in the supply voltage to the bridge. In order to remedy that problem, voltage regulators have been used with bridge power supplies. While that technique does remedy the problem, it can be quite expensive if the power supply is also connected to other apparatus, that is, where the power supply has a significant load. Additionally, if regulation is to be 1 percent or less of nominal voltage value, the regulator can be quite expensive even where relatively small loads are present.

US—3,728,626 discloses an indicator circuit including a bridge circuit in the form of a load cell with means for indicating weight applied to a measuring transducer. A ramp generator provides a ramp reference signal on a capacitor, the charge on which starts from a negative source voltage, passes through ground potential and increases to a positive source voltage. A comparison cycle with a bridge circuit signal is initiated as the charge passes through ground potential. A digital indication of weight is obtained from the time taken to change the capacitor charge from ground potential to that of the bridge circuit signal. For this purpose, a special power supply is needed to provide equal and opposite voltages on either side of the ground potential. Further, the variation of charge on the capacitor must start before initiation of the comparison cycle which itself continues until the bridge circuit signal has been measured.

The invention seeks to solve the problem in an inexpensive manner, and comprises an indicator circuit having an output corresponding to the departure of a sensed condition from a particular condition, including a bridge circuit, connected to a voltage source to produce a reference voltage, proportional to the voltage of the source, and an error voltage, the change in which from a "zero" point corresponding to the reference voltage is proportional to the departure of the condition sensed from the particular condition, characterised by a capacitor to which is initially applied a voltage corresponding to the "zero" point of the error voltage, means to initiate capacitor charge from the voltage source, and output means to provide an indication of time taken for the capacitor voltage to change to the error voltage, which time is independent of voltage source variation.

In a described embodiment of the invention, a circuit combines an error-sensing bridge circuit with an analogue to digital converter comprised of a charging capacitor, a comparator and a counter. The effect of variation in the error voltage due to variation in power supply voltage is matched with the effect of variation in the capacitor voltage due to variation in power supply voltage. Through the matching of these voltages and the configuration of the circuit, a range of digital output is caused to track the analogue range of error in the sensed condition in a manner independent of supply voltage variation.

The scope of the invention is defined by the appended claims; and how it can be carried into effect is hereinafter described with reference to the accompanying drawings, in which:—

Figure 1 is a circuit diagram of a circuit according to the invention;

Figure 2 is a graphical representation of the voltage levels on the charging capacitor against time; and

Figure 3 is a graphical representation of the error voltage produced against changes in the sensed condition.

The described embodiment of the invention is for use with the fuser of an electrophotographic copying machine in which one of the resistance values in the bridge is a thermistor which is used to control the measure of the temperature of the fuser through a variation of the thermistor resistance with that temperature. The bridge output is supplied to an analogue-to-digital converter which provides a digitized output representative of the temperature deviation from the desired control point. That output may then be used to regulate the amount of power applied to the fuser heater for the requisite time period in order to bring the fuser temperature back to the desired control point. Obviously, should the voltage input to the bridge change, the result would be a digital output which would provide an incorrect amount of power to the fuser unless that variation in supply voltage was compensated. This embodiment ensures that as supply voltage changes, input to the power control over the fuser does not become inaccurate. This invention may be applied in circuits sensing conditions other than temperature, such as speed or fluid level, for example, and the implementing circuits may then change appropriately. However, the essence of the invention which will now be described, will be the same regardless of application.

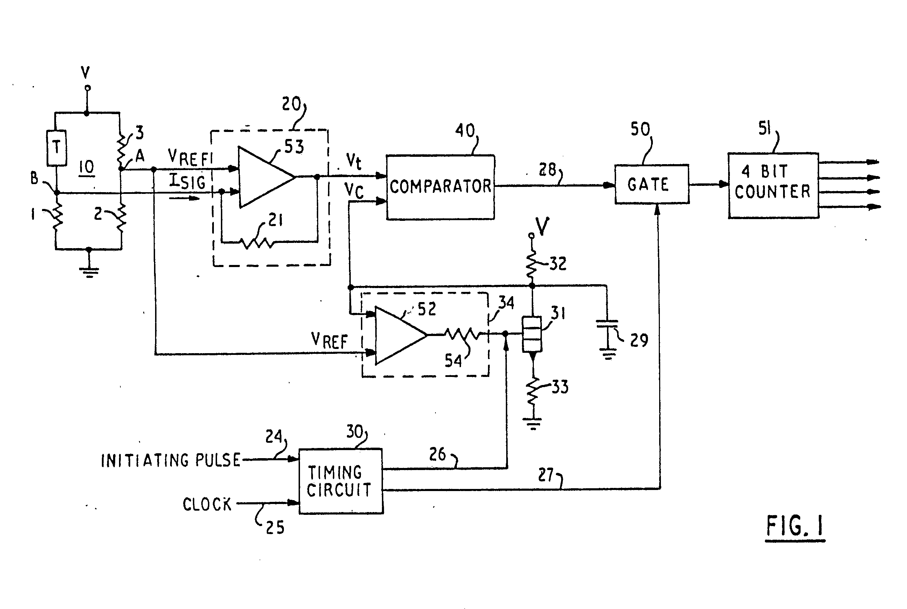

In Figure 1, a bridge circuit 10 receives a supply voltage V which is, for illustration, a nominal +8.5 volts with a tolerance range of ±10 percent. A thermistor T, together with a resistor $R^1$, is located in one leg of the bridge while the other leg of the bridge includes a resistor $R^3$ and a resistor $R^2$. While other resistance values could be chosen, it is always simple to match component bridge resistances such that the resistance $R_1$ of resistor 1=the resistance $R_2$ of the resistor 2 and at the desired control temperature the resistance $R_T$ thermistor T=the resistance $R_3$ of the resistor 3.

The output of bridge circuit 10 is supplied to a current to voltage converter 20, which is comprised essentially of an operational amplifier 53 which forces the signal voltage at point B to equal the reference voltage at point A. The output of operational amplifier 53 is an error voltage $V_t$, which is proportional to the resistances in the bridge circuit together with an amplifier feedback resistor 21 whose resistance is $R_{21}$. The equation for the circuit is:

$$V_t=V[R_2+R_{21}((R_2/R_1-(R_3/R_T))]/(R_3+R_2)$$

In the circuit shown in Figure 1 with $R_1=R_2$, the current level $I_{SIG}$ is zero when the sensed condition, i.e., the temperature in this case, creates a resistance in the thermistor which is equal to $R_3$. As Figure 1 shows, the voltage at point A is in essence a reference voltage $V_{REF}$, while the current level $I_{SIG}$ from point B is in essence an error signal converted to an error voltage by converter 20. Consequently, when the circuit is set up so that $R_T=R_3$ at the desired zero point of temperature control source $I_{SIG}$ is zero at that temperature and the error voltage corresponds to the reference voltage.

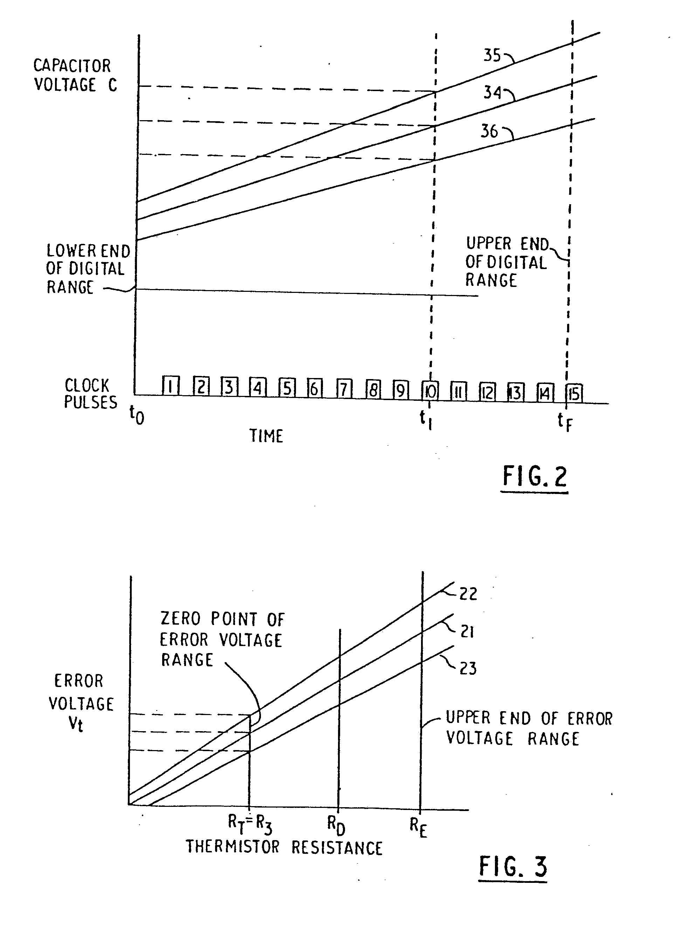

Referring now to Figure 3, there is shown a graphical representation of the rise in error voltage $V_t$ as the thermistor resistance $R_T$ increases. For example, at a nominal power supply voltage of +8.5 volts, the error voltage produced for various thermistor resistance values is shown by curve 21. Curve 22 represents the curve for the case where the power supply has increased by 10 percent and curve 23 indicates the curve for the case where power supply voltage has been decreased by 10 percent. Bridge balance is the condition where the thermistor resistance is equal to $R_3$ and, as previously stated, when $R_2=R_1$. Thus, Figure 3 shows that the magnitude of error voltage changes significantly with change in power supply voltage not only for error conditions, but also at bridge balance where the error voltage level should signify zero temperature error.

The voltage $V_{REF}$ at point A is applied as one input to a feedback amplifier 34 including an operational amplifier 52 whose output is through a resistor 54 to the base of a transistor 31. The emitter of transistor 31 is connected to earth through a resistor 33 and the collector of the transistor 31 is connected through a resistor 32 to supply voltage V. The collector of transistor 31 is also connected to one side of a capacitor 29 whose other side is earthed, and to another input to the operational amplifier 52.

A timing circuit 30 is connected to receive an initiating pulse on input 24 and clock pulses on input 25. The outputs of the circuit 30 are a signal on line 26 initiated by a pulse on line 24 and applied to the base of the transistor 31 to turn it off, and clock pulses on line 27 connected to a gate 50.

The non-earthed side of the capacitor 29, voltage $V_c$, is connected to one input of a comparator 40, whose other input is the error voltage $V_t$ from converter 20. The output of the comparator 40 on line 28 is used to control the gate 50, whose output is to a four-bit counter 51.

Initially the voltage $V_c$ on capacitor 29 is forced to equal $V_{REF}$ (the voltage at point A) by the circuit including feedback amplifier 34 and transistor 31. Thus, the initial value of the capacitor voltage is set at a lower end of an error voltage range corresponding to the upper end of a temperature range to be tracked by the circuit of this invention. Note that the upper end of the temperature range to be tracked is the desired control point and therefore the low end of the error voltage range represents the control point. This value will henceforth be called the zero point of the error voltage range. Referring to Figure 3, this zero point is shown for the $R_T=R_3$ condition, and the change in error voltage with power supply variation at the zero point is clearly shown. Figure 3 also shows the upper end of the range to be tracked at $R_T=R_E$.

Referring to Figures 1 and 2, at time $t_0$, an initiating pulse 24 is fed to the timing circuit 30, producing a signal on line 26 which turns off transistor 31. By so doing, the capacitor 29 begins to charge through resistor 32, causing its voltage to ramp towards the power supply level (V). The equation for the capacitor circuit during the charging period is:

$$V_c=V(1-(R_3/(R_3+R_2)e^{-T/R_{32}C_{29}}),$$

where $R_{32}$ is the resistance of resistor 32 and $C_{29}$ is the capacitance of capacitor 29.

Referring to Figure 2, the capacitor voltage increases during a time period $t_0-t_F$, during which 15 clock pulses are provided. This arbitrarily selected time period represents the length of time for the capacitor to charge from its initial value to a value equal to a particular error voltage. Curve 34 represents the charging of the capacitor when a supply voltage is at a nominal value, e.g. +8.5 volts. Curve 35 represents the charging of the capacitor when the supply voltage is at a +10 percent tolerance and curve 36 represents the charging of the capacitor when the supply voltage is at a −10 percent tolerance.

In Figure 3, curves 21, 22 and 23 show that when the temperature level is sensed as too low the error voltage increases to a level indicative of the amount by which the temperature is too low. Thus, for a particular thermistor resistance value equal to $R_D$, for example, a particular error voltage will be present as an input to the comparator 40 in Figure 1. Time is not a factor in the diagram shown in Figure 3 but rather the sensed temperature is the factor denoting at what point on the sloping curve 21, 22 and 23 the error voltage will be indicated. For different supply voltages the same thermistor resistance produces different error voltages. In Figure 2 it is seen that the charge level on the capacitor builds to a different value during a particular time period $t_o$—$t_I$ (ten clock pulses) depending upon the supply voltage. Consequently, three different curves, 34, 35 and 36, are shown, each reaching a different level by the end of time period $t_o$—$t_I$. It has now been recognized that these different levels can be used to offset changes in error voltage since in both instances the reason is the same, i.e., the change in supply voltage. Consequently, the ramping capacitor voltage can be used to create a condition where the output is independent of the supply voltage variation.

Referring again to Figure 1, the manner in which this is accomplished is shown through the inputs to the comparator 40. As long as the error voltage $V_t$ is at a value in excess of the capacitor voltage $V_c$, gate 50 is closed, allowing counter 51 to count clock pulses from line 27. When the ramping capacitor voltage reaches a level just in excess of the error voltage, a signal is enabled on line 28, opening gate 50 to end the counting cycle. Thus, the count is dependent upon the length of time it takes the ramping capacitor voltage to reach the magnitude of the error signal. Because both the ramping capacitor voltage and the error voltage change proportionately to variations in power supply voltage, the count is made independent of supply voltage variation. If the fuser is cold, $R_T$ may be greater than $R_E$ (Figure 3), and therefore higher than the upper end of the error voltage range. In this case the capacitor voltage does not reach the error voltage level during the period $t_o$–$t_f$ (Figure 2). In this situation the circuit is reset to its initial value and full power is supplied to the fuser.

The sequence is as follows. At time $t_o$, a pulse 24 is received by the timing circuit 30, causing clock pulses to be provided through gate 50 to counter 51. Simultaneously, the initiating pulse on line 24 turns off transistor 31, enabling the voltage on the capacitor to ramp upwardly from its initial value towards the power supply voltage V, e.g. +8.5±10 percent. As the capacitor voltage ramps upwardly, at some point it will exceed the error voltage (assuming the fuser temperature is in the tracking range). At that point the signal is enabled on line 28, the gate 50 is opened and the counter supplies the count of clock pulses counted during the time period to a processor (not shown) which translates the count into the amount of power which must be supplied to the heater of the fuser in order to bring the temperature back to a desired level.

If the temperature is outside the tracking range by being at the desired level or above, the voltage on the capacitor will exceed the error voltage immediately and thus the count from counter 51 is zero and the fuser heater will not be energized. If the temperature is outside the tracking range by being too cold, full power will be supplied.

To perform in the manner described, the capacitor-charging circuit has to satisfy two requirements. First, the capacitor-charging circuit must always start from the zero point of the analogue voltage range. That is to say, it must start at that particular error voltage which indicates zero temperature error. Consequently, no matter what the supply voltage, the capacitor ramps from a voltage value which signifies zero temperature error. The second requirement of the capacitor-charging circuit is that the time constant $R_{32}C_{29}$ must be chosen such that the capacitor charges to nominal full scale error voltage in the amount of time that the clock takes to make the counter count the full digital scale which, in the example shown (4-bit counter), is 15. Full-scale error voltage corresponds to that fuser temperature at which 100 percent power is needed.

By meeting the above circuit requirements, the charging equation for the capacitor and the equation for error voltage, both of which are dependent upon variation in supply voltage, result in a cancellation of the effect of the variation in supply voltage by creating a definite time at which the count is decoded for a certain temperature error. Thus, as the supply voltage varies, the digital output always tracks the analogue range of temperatures.

It should be noted that while the curves shown in Figures 2 and 3 are linear for ease of illustration, the capacitor voltage is actually exponential as previously set forth and thermistor values also change at a non-linear rate. For other applications, the capacitor voltage ramp can be made truly linear by the use of a current source dependent upon V used in place of resistor $R_{32}$.

While the invention has been particularly shown and described with reference to a preferred embodiment thereof, it will be understood by those skilled in the art that the foregoing and other changes in form and details may be made therein without departing from the scope of the invention.

In the example described, a simple control, only applying heat, is involved. If a control which enables cooling and heating is used, then output counts 0 to 7 may be used for cooling and 8 to 15 for heating to centralise the sensed condition $R_T$ on the particular condition $R_D$. The "zero" point corresponds to $R_T = R_3$.

The circuit described provides an indication of time taken for the capacitor voltage to rise to the error voltage, so that the variation of capacitor charge is an increase. The invention may involve the use of a negative voltage source with suitable modifications so that the capacitor undergoes a discharge to reach the error voltage.

## Claims

1. An indicator circuit having an output corresponding to the departure of a sensed condition from a particular condition, including a bridge circuit (10), connected to a voltage source (V) to produce a reference voltage ($V_{REF}$) proportional to the voltage of the source, and an error voltage ($V_t$), the change in which from a "zero" point corresponding to the reference voltage is proportional to the departure of the condition sensed from the particular condition, characterised by a capacitor (29) to which is initially applied a voltage corresponding to the "zero" point of the error voltage, means (24, 26, 31) to initiate capacitor charge from the voltage source (V), and output means (40, 50, 27, 51) to provide an indication of time taken for the capacitor voltage ($V_c$) to change to the error voltage ($V_t$), which time is independent of voltage source variation.

2. A circuit according to claim 1, in which the output means includes a comparator (40) to compare error voltage ($V_t$) and capacitor voltage ($V_c$) and to signal equality (28).

3. A circuit according to claim 2, in which the output means includes a source of clock pulses (25, 30, 27, 50) and a counter (51) whose count is changed by receipt of clock pulses upon initiation of capacitor charge variation, the change in count being stopped upon a signal (28) of comparator equality.

4. A circuit according to claim 3, in which the count in the counter (51) is incremented by each clock pulse received.

5. A circuit according to claim 3 or 4, in which the resultant count in the counter (51) is used to control correction of the sensed condition.

6. A circuit according to claim 5, in which the capacitor charge variation circuit has a time constant to enable the capacitor voltage to reach maximum error voltage during the time period needed for clock pulses to change the count in the counter (51) to a count corresponding to maximum corrective control.

## Revendications

1. Circuit d'indication d'erreur possédant une sortie qui correspond à l'écart que présente une condition détectée par rapport à une condition particulière, et comprenant un circuit en pont (10) connecté à une source de tension (V) de manière à produire une tension de référence ($V_{REF}$) proportionnelle à la tension de la source, et une tension d'erreur ($V_t$) dont l'écart par rapport à un point "zéro" correspondant à la tension de référence est proportionnel à l'écart que présente la condition détectée par rapport à ladite condition particulière, caractérisé en ce qu'il comprend un condensateur (29) auquel est initialement appliquée une tension correspondant au point "zéro" de la tension d'erreur, des moyens (24, 26, 31) permettant de déclencher le chargement du condensateur depuis la source de tension (V), et des moyens de sortie (40, 50, 27, 51) permettant d'indiquer le temps mis par la tension du condensateur ($V_c$) à passer à la tension d'erreur ($V_t$), lequel temps est indépendant des variations de la source de tension.

2. Circuit selon la revendication 1, caractérisé en ce que les moyens de sortie comprennent un comparateur (40) permettant de comparer la tension d'erreur ($V_t$) et la tension du condensateur ($V_c$), et d'engendrer un signal d'égalité (sur la ligne 28).

3. Circuit selon la revendication 2, caractérisé en ce que les moyens de sortie comprennent une source d'impulsions d'horloge (25, 30, 27, 50) et un compteur (51) dont la valeur est modifiée par la réception d'impulsions d'horloge lors du déclenchement du chargement du condensateur, le compteur cessant de compter lors de la réception d'un signal d'égalité fourni par le comparateur (sur la ligne 28).

4. Circuit selon la revendication 3, caractérisé en ce que la valeur du compteur (51) est incrémentée par chaque impulsion d'horloge reçue.

5. Circuit selon la revendication 3 ou 4, caractérisé en ce que la valeur résultante du compteur (51) permet de commander la correction de la condition détectée.

6. Circuit selon la revendication 5, caractérisé en ce que le circuit de variation de charge du condensateur présente une constante de temps permettant à la tension du condensateur d'atteindre une valeur maximum d'erreur pendant l'intervalle de temps nécessaire pour que les impulsions d'horloge fassent passer la valeur du compteur (51) à une valeur correspondant à une commande de correction maximum.

## Patentansprüche

1. Eine Anzeigeschaltung mit einem Ausgangssignal entsprechend der Abweichung einer abgetasteten Bedingung von einer vorgegebenen Bedingung, mit einer Brückenschaltung (10), die an eine Spannungsquelle (V) angeschlossen ist zur Bereitstellung eines Bezugsspannungssignals ($V_{REF}$) proportional zur Spannung der Quelle und mit einer Fehlerspannung ($V_t$), deren Änderung von einem "Null"-Punkt entsprechend der Referenzspannung proportional ist der Abweichung der abgetasteten Bedingung von der vorgegebenen Bedingung, gekennzeichnet durch einen Kondensator (29), an den anfänglich eine Spannung angelegt wird, die dem "Null"-Punkt der Fehlerspannung entspricht, durch eine Einrichtung (24, 26, 31) zur Aufladung des Kondensators von der Spannungsquelle (V) und durch Ausgabeeinrichtungen (40, 50, 27, 51) zur Bereitstellung einer Anzeige für die Zeit, die erforderlich ist für eine Änderung der Kondensatorspannung $(V_c)$ entsprechend der Fehlerspannung $(V_t)$ und die unabhängig von einer Veränderung der Spannungsquelle ist.

2. Eine Schaltung nach Anspruch 1, worin die Ausgabeeinrichtung einen Vergleicher (40) zum Vergleich der Fehlerspannung $(V_t)$ und der Kondensatorspannung $(V_c)$ und zur Signalisierung eines Gleich-Signals (28).

3. Eine Schaltung nach Anspruch 2, worin die Ausgabeeinrichtung eine Taktimpulsquelle (25, 30, 27, 50) und einen Zähler (51) enthält, dessen Zählstand durch den Empfang der Taktimpulse geändert wird nach Auslösung einer Veränderung der Kondensatorladung, wobei eine Veränderung des Zählstandes durch das Gleich-Signal (28) vom Komparator unterbunden wird.

4. Eine Schaltung nach Anspruch 3, worin der Zählstand im Zähler (51) durch jeden empfangenen Taktimpuls inkrementiert wird.

5. Eine Schaltung nach Anspruch 3 oder 4, worin der resultierende Zählstand im Zähler (51) zur Steuerung einer Korrektur der abgetasteten Bedingung dient.

6. Eine Schaltung nach Anspruch 5, worin die Schaltung zur Veränderung der Kondensatorladung eine Zeitkonstante aufweist, die es der Kondensatorspannung ermöglicht, die maximale Fehlerspannung während der Zeitperiode zu erreichen, die von den Taktimpulsen benötigt wird, um den Fehler (51) auf einen Zählstand weiterzuschalten, der einer maximalen Korrekturkontrolle entspricht.

FIG. 1

FIG.2

FIG.3